# EUROPEAN PATENT APPLICATION

(11) **EP 3 026 142 A1**
(43) Date of publication of application: **01.06.2016**
(21) Application number: 15196130.7
(22) Date of filing: 24.11.2015
(51) Int. Cl.: C23C 16/24

(54) **HIGH TEMPERATURE, LOW OXIDATION, AMORPHOUS SILICON-COATED TITANIUM**

(30) Priority: 26.11.2014 US 201414554545
(71) Applicant: Rohr, Inc., Chula Vista, CA 91910-2098 (US)
(72) Inventor: PIERICK, David E., San Diego, CA 92127 (US); ALLOWAY, Richard S., San Diego, CA 92131 (US)
(74) Representative: Leckey, David Herbert

(57) **Abstract**

An exhaust system (200; 300) for a gas turbine engine may comprise a titanium alloy substrate. The titanium alloy may comprise IMI 834, titanium 1100, titanium 6242, or Beta-21 S. An amorphous silicon oxygen barrier layer (410) may be coupled to the titanium alloy substrate. The amorphous silicon oxygen barrier layer (410) may be deposited by chemical vapor deposition. The exhaust system (200; 300) may have a high creep resistance and be protected from oxidation.

## Description

### FIELD

The present disclosure relates to titanium material systems that are capable of withstanding high temperatures and are resistant to oxygen degradation so that they adequately maintain their mechanical properties for a long life span.

### BACKGROUND

Turbine engine primary exhaust nozzles and center bodies are designed to direct the flow of hot exhaust gas from the engine core. Frequently, the exhaust components may be made of a titanium alloy. However, the requirements of turbine engine exhaust systems are beginning to stretch and exceed the current capabilities of known titanium alloy material systems. The exhaust gas temperatures in modem engines continue to increase as manufacturers increase the power and efficiency of engines. At such high temperatures, particularly above 800 °F (430 °C), conventional titanium alloys may be susceptible to oxidation degradation. The amount of oxidation degradation increases with increasing temperature and exposure time. Oxidation in titanium typically involves adsorption-controlled dissolution of oxygen. Oxidation greatly degrades the fatigue life and ultimate strength of conventional titanium alloys.

As an alternative when titanium is not feasible, exhaust components may be made from an austenitic nickel-chromium-based alloy such as those available under the trademark Inconel®. However, Inconel is significantly more dense than conventional titanium alloys, and thus can add significant weight to an exhaust system. As another alternative, some exhaust components may include a ceramic coating on titanium to decrease oxidation. However, ceramic coatings tend to be brittle and may crack or otherwise fail under thermal cycling and often do not last as long as the desired life span of the exhaust component part.

For this application (high temperature turbine engine exhaust components) and many others, there is a need for a titanium-based material system with higher temperature capabilities which maintains adequate mechanical properties over a long life span and many thermal cycles.

### SUMMARY

A component may comprise a titanium alloy substrate and an oxygen barrier layer. The oxygen barrier layer may comprise an amorphous silicon. The oxygen barrier layer may be coupled to the titanium alloy substrate. The component may be located within a high temperature environment.

In various embodiments, the component may be located within an extreme temperature environment. The titanium alloy substrate may comprise at least one of IMI 834, titanium 1100, titanium 6242, or Beta-21S. The oxygen barrier layer may comprise a plurality of layers of amorphous silicon. The oxygen barrier layer may be deposited by chemical vapor deposition. The oxygen barrier layer may be configured to prevent oxidation of the titanium alloy substrate. The component may be an exhaust nozzle center body, a primary exhaust nozzle fairing, a primary exhaust nozzle, a center vent tube, or an aft pylon fairing heat shield. The titanium alloy substrate may comprise a core of an acoustic honeycomb structure. A thickness of the oxygen barrier layer may be between 1-10 microns.

An exhaust system for a gas turbine engine may comprise a primary exhaust nozzle fairing, a primary exhaust nozzle located within the primary exhaust nozzle fairing, and a center body located within the primary exhaust nozzle. The center body may comprise a titanium alloy substrate having an amorphous silicon coating disposed on a surface of the titanium alloy substrate.

In various embodiments, the center body may comprise at least one of IMI 834, titanium 1100, titanium 6242, or Beta-21S. The primary exhaust nozzle may comprise amorphous silicon coated titanium alloy. The component may be located within a high temperature environment. The amorphous silicon coating may be configured to prevent oxidation of the titanium substrate. The center body may comprise an acoustic honeycomb structure. A core of the acoustic honeycomb structure may comprise an amorphous silicon coated titanium alloy.

The foregoing features and elements may be combined in various combinations without exclusivity, unless expressly indicated otherwise. These features and elements as well as the operation thereof will become more apparent in light of the following description and the accompanying drawings. It should be understood, however, the following description and drawings are intended to be exemplary in nature and non-limiting.

### BRIEF DESCRIPTION OF THE DRAWINGS

The subject matter of the present disclosure is particularly pointed out and distinctly claimed in the concluding portion of the specification. A more complete understanding of the present disclosure, however, may best be obtained by referring to the detailed description and claims when considered in connection with the drawing figures, wherein like numerals denote like elements.
FIG. 1 illustrates a perspective view of a nacelle in accordance with various embodiments;
FIG. 2 illustrates a perspective view of an exhaust system in accordance with various embodiments;
FIG. 3 illustrates an enlarged view of an exhaust system in accordance with various embodiments;
FIG. 4 illustrates a cross section view of a titanium exhaust component in accordance with various embodiments; and
FIG. 5 illustrates a perspective view of an acoustic honeycomb structure in accordance with various embodiments.

### DETAILED DESCRIPTION

The detailed description of various embodiments herein makes reference to the accompanying drawings, which show various embodiments by way of illustration. While these various embodiments are described in sufficient detail to enable those skilled in the art to practice the inventions, it should be understood that other embodiments may be realized and that logical, chemical and mechanical changes may be made without departing from the scope of the inventions. Thus, the detailed description herein is presented for purposes of illustration only and not of limitation. For example, the steps recited in any of the method or process descriptions may be executed in any order and are not necessarily limited to the order presented.

Furthermore, any reference to singular includes plural embodiments, and any reference to more than one component or step may include a singular embodiment or step. Also, any reference to attached, fixed, connected or the like may include permanent, removable, temporary, partial, full and/or any other possible attachment option. Additionally, any reference to without contact (or similar phrases) may also include reduced contact or minimal contact.

For high temperature environments where titanium is desired as a material system to construct a component, there are several known titanium alloys which perform well at high temperatures (e.g. exhibit good mechanical properties at the high temperature similar to the characteristic desirable properties of titanium at lower temperatures, for example a high creep strength). Examples include titanium 1100, IMI 834, titanium 6242, or Beta-21S. However, these alloys all suffer from a susceptibility to oxygen degradation through adsorption-controlled dissolution of oxygen in high temperature environments. As used herein, a "high temperature environment" refers to an environment at a temperature greater than 800 °F (430 °C), and an "extreme temperature environment" refers to an environment at a temperature greater than 1100 °F (590 °C). In general, titanium 6242 and Beta-21S may exhibit good mechanical properties in high temperature environments, and titanium 1100 and IMI 834 may exhibit good mechanical properties in high or extreme temperature environments.

Heretofore there have not been titanium material systems that exhibit the desirable combination at high temperatures of good mechanical properties and low susceptibility to oxygen degradation.

Coatings have been proposed for titanium that will block oxygen degradation. In particular, U.S. Patent No. 4,681,818 to Unnam et al. and assigned to NASA proposes applying as an oxygen barrier a SiO₂ coating to titanium using chemical vapor deposition (CVD) techniques. However, the present inventors believe this system has several disadvantages including coating brittleness, such that the coating degrades and becomes ineffective over many thermal cycles similar to other ceramic coatings.

The present inventors' experimental results have confirmed that an amorphous silicon coating may be applied to high temperature-capable titanium alloys and effectively block oxygen without the drawbacks of other proposed coatings. Amorphous silicon coating has not been previously known as an oxygen barrier coating, but the inventor's results have shown an adequate effectivity. As opposed to crystalline silicon, which may be brittle, the amorphous silicon coating may be capable of slowing moving or flowing, which may decrease the risk of cracking over time.

Accordingly, an exhaust nozzle or other component in a high temperature environment may be constructed from a high temperature titanium alloy, such as IMI 834, which has a composition of Ti-5.8%Al-4%Sn-3.5%Zr-0.7%Nb-0.5%Mo-0.3%Si (referred to herein as "IMI 834"), or a high temperature titanium alloy comprising Ti-6%Al-2.7%Sn-4%Zr-0.4%Mo-0.45%Si and available under the trademark TIMET TIMETAL® 1100 titanium alloy (referred to herein as "titanium 1100"), TIMET TIMETAL® 6-2-4-2 (Ti-6%Al-2%Sn-4%Zr-2%Mo-0.08%Si) titanium alloy (referred to herein as "titanium 6242"), or TIMET TIMETAL® 21S Titanium Alloy (Ti-15%Mo-3%Nb-3%Al-0.2%Si, ASTM Grade 21) (referred to herein as "Beta-21S"). The titanium alloy may have a high creep resistance in high temperature environments, such as above 800 °F (430 °C). Creep resistance refers to a material's ability to resist distortion when under a load for an extended period of time. An amorphous silicon coating may be applied to the titanium components. The amorphous silicon coating may be applied by a chemical vapor deposition process. The amorphous silicon coating may decrease oxidation degradation at high temperatures. Thus, the exhaust nozzle may comprise lightweight titanium components which can withstand creep and oxidation at high temperatures.

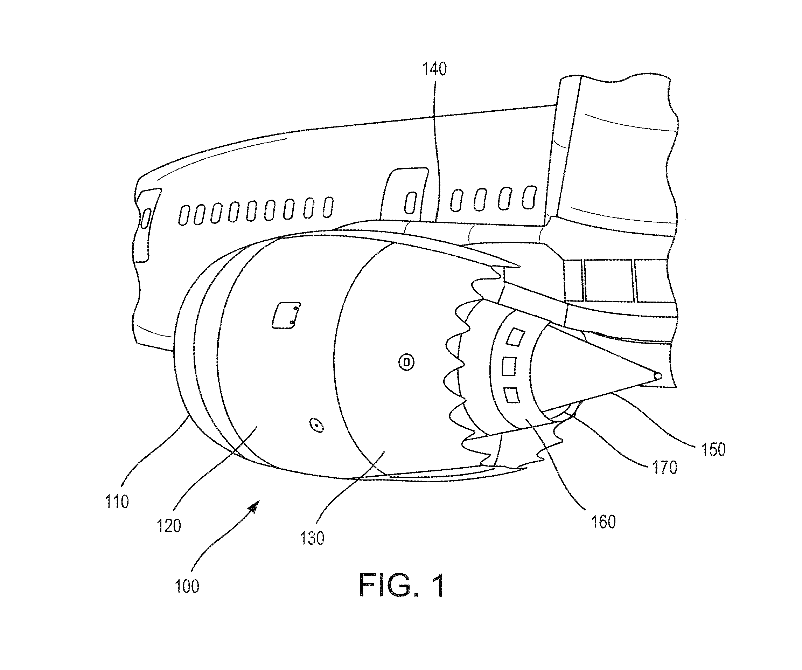

Referring to FIG. 1, a nacelle 100 for a gas turbine engine is illustrated according to various embodiments. Nacelle 100 may comprise an inlet 110, a fan cowl 120, and a thrust reverser 130. Nacelle 100 may be coupled to a pylon 140, which may mount the nacelle 100 to an aircraft wing or aircraft body. Nacelle 100 may further comprise an exhaust nozzle center body 150. Hot gas from a gas turbine engine may exit the gas turbine engine around the exhaust nozzle center body 150. A primary exhaust nozzle fairing 160 and a primary exhaust nozzle 170 may surround the exhaust nozzle center body 150.

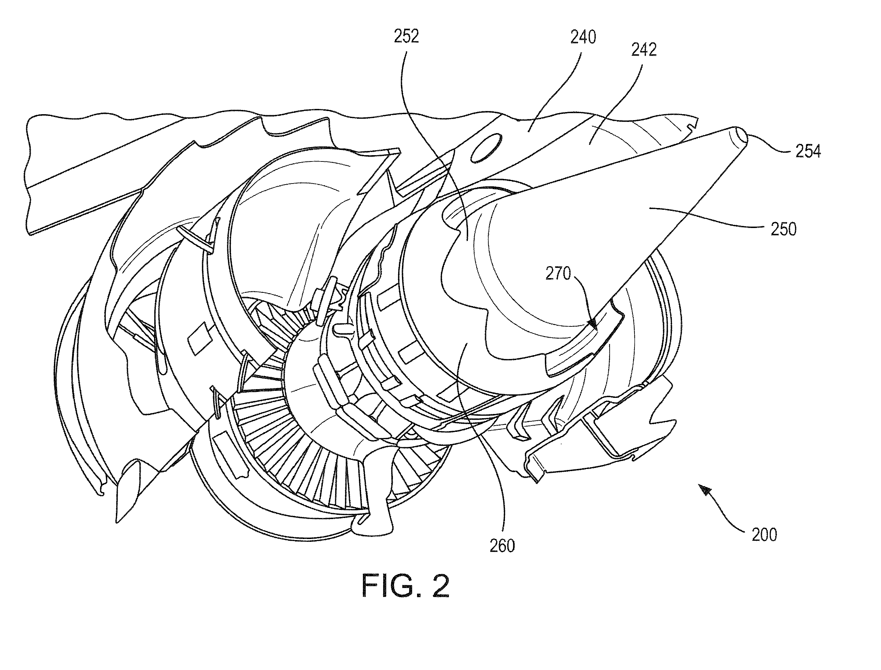

Referring to FIG. 2, an exhaust system 200 in a gas turbine engine is illustrated according to various embodiments. Exhaust may be expelled from the gas turbine engine through a primary exhaust nozzle 270. The exhaust flow path through the primary exhaust nozzle 270 may be defined by the primary exhaust nozzle 270 and an exhaust nozzle center body 250. A center vent tube 254 may vent air from one or more air/oil separators through the exhaust nozzle center body 250. The exhaust nozzle center body 250 may comprise a center body acoustic region 252. The center body acoustic region 252 may comprise a perforated top skin and an internal honeycomb structure which reduces noise emanating from the exhaust system 200 in a known manner. In various embodiments, the primary exhaust nozzle 270 may likewise comprise an acoustic region. The exhaust system may be subjected to temperatures of up to 1,300 °F (700 °C) or greater. An aft pylon fairing 240 may comprise an aft pylon fairing heat shield 242. The aft pylon fairing heat shield 242 may protect the aft pylon fairing 240 from the high temperature of the exhaust and thus may also be exposed to the same or similar high temperatures as the center body 250 and nozzle 270.

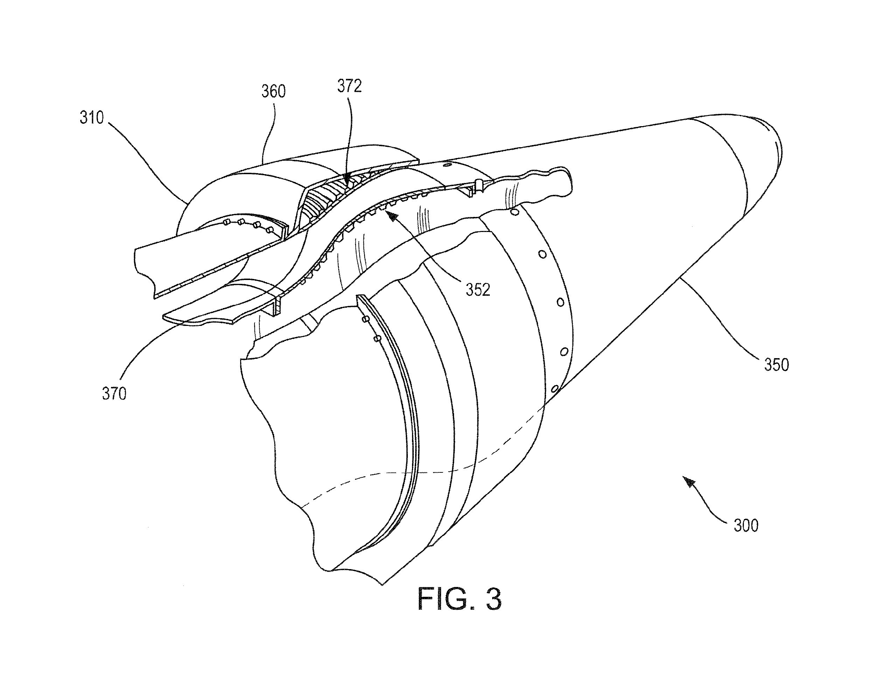

Referring to FIG. 3, an enlarged view of an exhaust system 300 is illustrated according to various embodiments. The exhaust system 300 may comprise an exhaust nozzle 310 and a center body 350. The exhaust nozzle 310 may comprise a primary exhaust nozzle 370 (also known as a nozzle inner barrel) and a primary exhaust nozzle fairing 360 (also known as a nozzle outer barrel). In various embodiments, the primary exhaust nozzle 370 may comprise an internal honeycomb structure 372 which attenuates noise in a known manner. In various embodiments, the center body 350 may likewise comprise an internal honeycomb structure 352 which attenuates noise in a known manner. However, in various embodiments, the exhaust system 300 does not comprise any acoustic structures.

In various embodiments, at least one of the primary exhaust nozzle 270, the exhaust nozzle center body 250, the center body acoustic region 252, the center vent tube 254, the primary exhaust nozzle fairing 260, and the aft pylon fairing heat shield 242 may comprise a high temperature titanium alloy. A high temperature titanium alloy may be a near alpha titanium alloy, such as IMI 834, titanium 1100, titanium 6242, or Beta-21S. High temperature titanium alloys may have greater creep resistance than conventional titanium alloys.

However, although titanium 1100 and IMI 834 may have a high creep resistance, titanium 1100 and IMI 834, as well as other titanium alloys, are subject to oxidation degradation, particularly at temperatures over 800 °F (430 °C). An oxygen barrier layer may be applied to the titanium components in order to prevent oxidation degradation in high temperature environments and extreme temperature environments, including at temperatures up to 1,300 °F (700 °C) or greater. The oxygen barrier layer may comprise an amorphous silicon. In various embodiments, the amorphous silicon may be deposited by chemical vapor deposition in a vacuum. The oxygen barrier layer may decrease oxidation degradation which mitigates the large drop in fatigue and static strength from long exposures. These large drops limit the temperature capability of these materials. Oxidation coating allows the benefits of increased creep strength to be realized in high temperature environments.

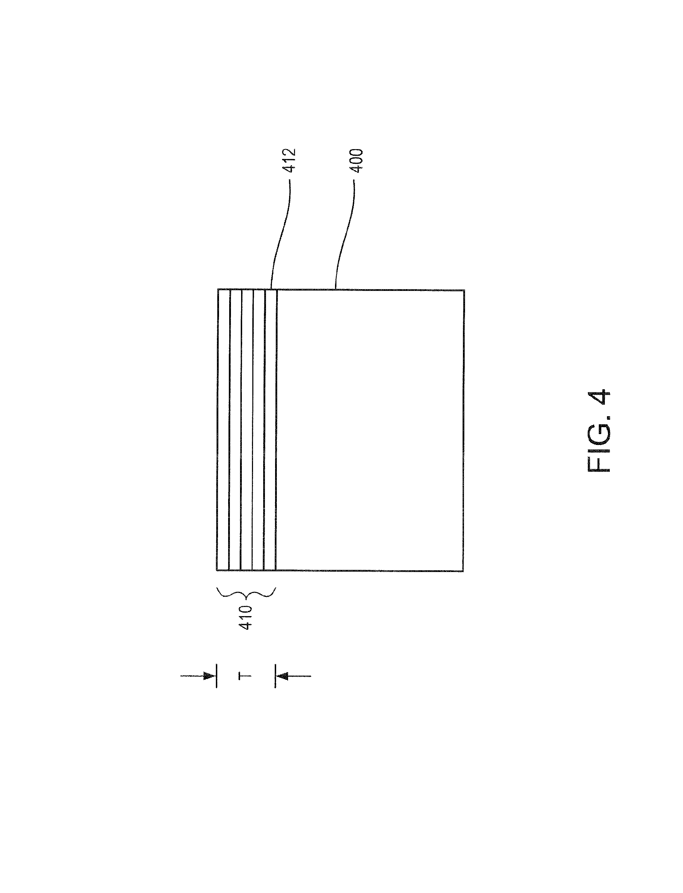

Referring to FIG. 4, a titanium component 400 having an oxygen barrier layer 410 is illustrated according to various embodiments. The titanium component 400 may comprise a high temperature titanium alloy, such as IMI 834, titanium 1100, titanium 6242, or Beta-21S, which exhibits a high creep resistance.

The oxygen barrier layer 410 may comprise an amorphous silicon. Amorphous silicon is the non-crystalline allotropic form of silicon. The atoms in amorphous silicon may form a continuous random network. Additionally, amorphous silicon layers may be made thinner than crystalline silicon. The amorphous silicon may be more flexible than crystalline silicon, and thus less susceptible to becoming brittle or cracking. Amorphous silicon may improve the oxidation resistance of the titanium exhaust components.

In various embodiments, the amorphous silicon may be applied to the titanium component 400 by chemical vapor deposition in a vacuum. Silane may be introduced to a treatment environment for the titanium component 400, and the silane may decompose into silicon and hydrogen. In various embodiments, a plurality of amorphous silicon layers 412 may be applied to create the oxygen barrier layer 410. In various embodiments, a thickness T of the oxygen barrier layer 410 may be from 1 micron to 10 microns (.00004 inches - .0004 inches).

In various embodiments, the silane may be heated to a temperature in the range from about 300 °C - 600 °C (570 °F - 1100 °F). The silane may be pressurized in a range from 100 Torr to 250 Torr (13 kPa to 33 kPa). After the deposition is complete, the system may be purged with an inert gas, and a binding reagent, such as ethylene, may be introduced under elevated temperature and pressure. For more information regarding chemical vapor deposition of amorphous silicon, see U.S. Patent No. 7,867,627 entitled, "PROCESS FOR THE MODIFICATION OF SUBSTRATE SURFACES THROUGH THE DEPOSITION OF AMORPHOUS SILICON LAYERS FOLLOWED BY SURFACE FUNCTIONALIZATION WITH ORGANIC MOLECULES AND FUNCTIONALIZED STRUCTURES," filed on December 13, 2005, and U.S. Patent No. 7,070,833, entitled, "METHOD FOR CHEMICAL VAPOR DEPOSITION OF SILICON ON TO SUBSTRATES FOR USE IN CORROSIVE AND VACUUM ENVIRONMENTS," filed on August 18, 2003.

In various embodiments, exhaust system components may comprise multiple materials, or any material configuration suitable to enhance or reinforce the resiliency and/or support of the system when subjected to wear in an aircraft operating environment or to satisfy other desired electromagnetic, chemical, physical, or biological properties, for example radar signature, load capacity, and/or heat tolerance.

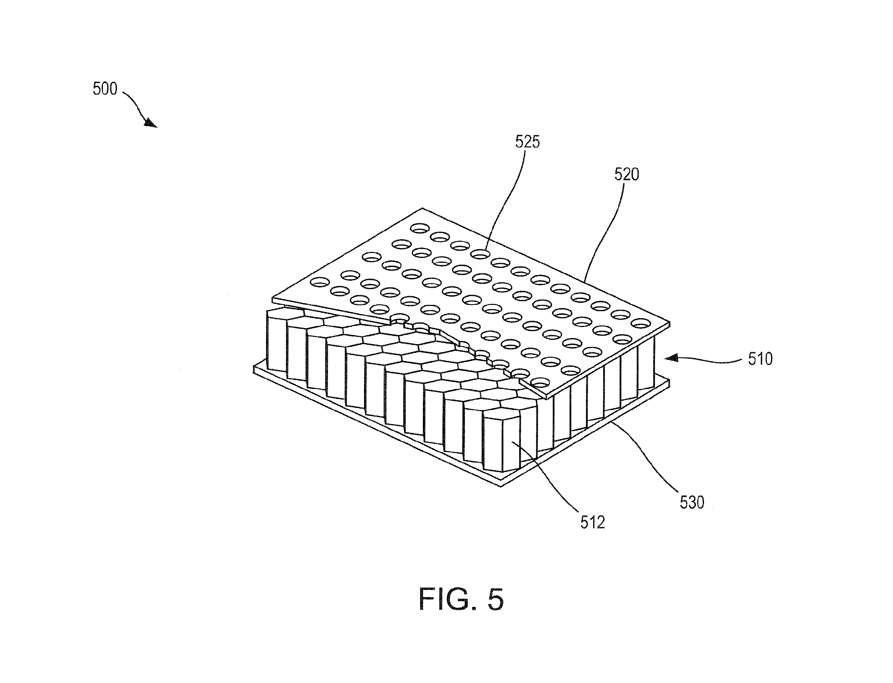

Referring to FIG. 5, an acoustic honeycomb structure 500 is illustrated according to various embodiments. The acoustic honeycomb structure 500 may comprise a core 510, positioned between a perforated top sheet 520 and a back skin 530. The core 510 may comprise a plurality of cells 512. The bottom of the acoustic honeycomb structure 500 may be closed by a generally rigid non-perforated back skin 530. A perforated top sheet 520 having perforations 525 may be coupled to the top of the acoustic honeycomb structure 500. Additional layers may be formed on top of the perforated top sheet 520 for airflow and/or acoustic properties as desired. The perforated top sheet 520, core 510, and back skin 530 combine to form cells 512 that become resonating chambers and work to damp acoustic emissions, such as sound waves from an aircraft engine.

The acoustic honeycomb structure 500 may be incorporated in the exhaust structure of an aircraft engine. For instance, referring temporarily to FIG. 2, the center body acoustic region 222 may comprise an acoustic honeycomb structure. The perforations 525 are configured to attenuate the engine's noise by damping the energy response, directing the sound into the cells 512 of the acoustic honeycomb structure 500 to allow reflected noise to cancel source noise.

In various embodiments, at least one of the perforated top sheet 520, the cells 512, or the back skin 530 may comprise a high temperature titanium alloy. An amorphous silicon oxygen barrier layer may be applied to the acoustic honeycomb structure 500. In various embodiments, the amorphous silicon oxygen barrier layer may be applied by chemical vapor deposition in a vacuum. The process may cause the silane to enter the cells 512 through the perforations 525 and deposit an amorphous silicon layer within the cells 512. Thus, the chemical vapor deposition process may allow for non-line of site structures, such as the interiors of the cells 512, to be coated with an amorphous silicon. Thus, the acoustic honeycomb structure 500 may have adequate oxidation resistance and creep resistance.

While the exhaust systems described herein have been described in the context of aircraft applications, one will appreciate in light of the present disclosure that the system described herein may be used in connection with various other vehicles, for example, a launch vehicle, a spacecraft, an unmanned aerial vehicle, a missile, cars, trucks, busses, trains, boats, and submersible vehicles, or any other vehicle or device, or in connection with industrial processes, or propulsion systems, or any other system or process having materials exposed to high temperatures.

In the detailed description herein, references to "one embodiment", "an embodiment", "various embodiments", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. After reading the description, it will be apparent to one skilled in the relevant art(s) how to implement the disclosure in alternative embodiments.

Benefits, other advantages, and solutions to problems have been described herein with regard to specific embodiments. Furthermore, the connecting lines shown in the various figures contained herein are intended to represent various functional relationships and/or physical couplings between the various elements. It should be noted that many alternative or additional functional relationships or physical connections may be present in a practical system. However, the benefits, advantages, solutions to problems, and any elements that may cause any benefit, advantage, or solution to occur or become more pronounced are not to be construed as critical, required, or essential features or elements of the inventions. The scope of the inventions is accordingly to be limited by nothing other than the appended claims, in which reference to an element in the singular is not intended to mean "one and only one" unless explicitly so stated, but rather "one or more." Moreover, where a phrase similar to "at least one of A, B, or C" is used in the claims, it is intended that the phrase be interpreted to mean that A alone may be present in an embodiment, B alone may be present in an embodiment, C alone may be present in an embodiment, or that any combination of the elements A, B and C may be present in a single embodiment; for example, A and B, A and C, B and C, or A and B and C. Different cross-hatching is used throughout the figures to denote different parts but not necessarily to denote the same or different materials.

## Claims

1. A component (400) comprising:
a titanium alloy substrate; and
an oxygen barrier layer (410) comprising amorphous silicon coupled to the titanium alloy substrate, wherein the component is located in a high temperature environment.

2. The component of claim 1, wherein the component (400) is located in an extreme temperature environment.

3. The component of claim 1 or 2, wherein the titanium alloy substrate (400) comprises at least one of IMI 834 (Ti-5.8%Al-4%Sn-3.5%Zr-0.7%Nb-0.5%Mo-0.3%Si), titanium 1100 (Ti-6%Al-2.7%Sn-4%Zr-0.4%Mo-0.45%Si), titanium 6242 (Ti-6%Al-2%Sn-4%Zr-2%Mo-0.08%Si), or Beta-21S (Ti-15%Mo-3%Nb-3%Al-0.2%Si, ASTM Grade 21).

4. The component of claim 1, 2 or 3, wherein the oxygen barrier layer (410) comprises a plurality of layers of amorphous silicon (412).

5. The component of any preceding claim, wherein the oxygen barrier layer (410) is deposited by chemical vapor deposition.

6. The component of any preceding claim, wherein the oxygen barrier layer (410) is configured to prevent oxidation of the titanium alloy substrate.

7. The component of any preceding claim, wherein the component (400) is at least one of an exhaust nozzle center body (150; 250; 350), a primary exhaust nozzle fairing (160; 260; 360), a primary exhaust nozzle (170; 270; 370), a center vent tube (254), or an aft pylon fairing heat shield (242).

8. The component of any preceding claim, wherein the titanium alloy substrate comprises a core (510) of an acoustic honeycomb structure (500).

9. The component of any preceding claim, wherein a thickness of the oxygen barrier layer (410) is between 1 micron and 10 microns.

10. An exhaust system (200; 300) for a gas turbine engine comprising:
a primary exhaust nozzle fairing (160; 260; 360);
a primary exhaust nozzle (170; 270; 370) located within the primary exhaust nozzle fairing (160; 260; 360); and
a center body (150; 250; 350) located within the primary exhaust nozzle (170; 270; 370), wherein the center body (150; 250; 350) comprises a titanium alloy substrate having an amorphous silicon coating disposed on a surface of the titanium alloy substrate.

11. The exhaust system of claim 10, wherein the center body (150; 250; 350) comprises at least one of IMI 834 (Ti-5.8%Al-4%Sn-3.5%Zr-0.7%Nb-0.5%Mo-0.3%Si), titanium 1100 (Ti-6%Al-2.7%Sn-4%Zr-0.4%Mo-0.45%Si), titanium 6242 (Ti-6%Al-2%Sn-4%Zr-2%Mo-0.08%Si), or Beta-21S (Ti-15%Mo-3%Nb-3%Al-0.2%Si, ASTM Grade 21).

12. The exhaust system of claim 10 or 11, wherein the primary exhaust nozzle (170; 270; 370) comprises amorphous silicon coated titanium alloy.

13. The exhaust system of claim 10, 11 or 12, wherein the center body (150; 250; 350) is located within a high temperature environment.

14. The exhaust system of any of claims 10 to 13, wherein the amorphous silicon coating is configured to prevent oxidation of the titanium alloy substrate.

15. The exhaust system of any of claims 10 to 14, wherein the center body (150; 250; 350) comprises an acoustic honeycomb structure (500), wherein a core (510) of the acoustic honeycomb structure (500) comprises an amorphous silicon coated titanium alloy.
